Europäisches Patentamt

European Patent Office

Office européen des brevets

(19)

(11) Veröffentlichungsnummer : **0 150 662**
**B1**

# EUROPÄISCHE PATENTSCHRIFT

(12)

(45) Veröffentlichungstag der Patentschrift :
02.03.88

(51) Int. Cl.⁴ : **H 05 K 13/02**

(21) Anmeldenummer : 84730131.4

(22) Anmeldetag : 04.12.84

(54) **Einrichtung zum Be- und Entladen von Bearbeitungseinrichtungen für Leiterplatten, insbesondere Bauelemente-Bestückungseinrichtungen.**

(30) Priorität : 06.12.83 DE 3344483

(43) Veröffentlichungstag der Anmeldung :
07.08.85 Patentblatt 85/32

(45) Bekanntmachung des Hinweises auf die Patenterteilung : 02.03.88 Patentblatt 88/09

(84) Benannte Vertragsstaaten :
AT BE CH DE FR GB LI NL SE

(56) Entgegenhaltungen :
GB-A- 2 113 189
US-A- 3 902 615
US-A- 4 062 463

(73) Patentinhaber : **Siemens Aktiengesellschaft Berlin
und München
Wittelsbacherplatz 2
D-8000 München 2 (DE)**

(72) Erfinder : **Witt, Günter, Ing. (grad.)
Küsterstrasse 32
D-1000 Berlin 20 (DE)**
Erfinder : **Wetzel, Edgar
Heilmannring 55
D-1000 Berlin 13 (DE)**
Erfinder : **Hartmut Hanke
Schwiegersteig 11
1000 Berlin 13 (DE)**
Erfinder : **Otto Schwartz
Kurpfalzstrasse 7
6749 Freckenfeld (DE)**

EP 0 150 662 B1

## Beschreibung

In automatisch arbeitenden Fertigungseinrichtungen für Flachbaugruppen werden die unbestückten bzw. die teilweise bestückten oder komplettierten Leiterplatten in Magazinen gespeichert. Die Magazine werden an Beladestationen gefüllt, wobei diese Beladestationen auch den Ausgangsbereich anderer Fertigungseinrichtungen darstellen können. Häufig sind die einzelnen Bearbeitungseinrichtungen durch eine oder mehrere Förderanlagen zu einer Fertigungsanlage verkettet. Am Ort der Bearbeitungseinrichtungen sind dann jeweils Einrichtungen angeordnet, die dem Überführen von Leiterplatten zwischen dem Magazin und der entsprechenden Bearbeitungseinrichtung dienen ; insbesondere Bauelemente-Bestückeinrichtungen werden auf diese Weise mit einzelnen Leiterplatten versorgt.

Um die Kapazität der Bauelemente-Bestückeinrichtungen möglichst umfassend nutzen zu können, ist an solche Einrichtungen zum Überführen von Leiterplatten die Forderung zu stellen, daß die Überführzeiten so kurz wie möglich gehalten werden. Diese Forderung wird von einigen bekannten Einrichtungen zum Überführen von Leiterplatten zwischen einem Magazin und einer Leiterplatten-Bearbeitungseinrichtung nicht optimal erfüllt. Beispielsweise besteht bei einer bekannten derartigen Einrichtung die Fördereinrichtung aus einem Förderwagen, auf dem ein Magazin gelagert ist. Am Ort von Prüfstationen befindet sich jeweils ein einarmiger Roboter, der zu prüfende Baugruppen aus dem Magazin entnimmt und auf eine Prüfaufnahme aufsetzt. Nach Beendigung der Prüfung wird die Baugruppe in ein ortsfest aufgestelltes weiteres Magazin oder in das auf dem Förderwagen befindliche Magazin überführt und anschließend die nächste zu prüfende Baugruppe aus dem Magazin entnommen und erneut auf die Prüfaufnahme aufgesetzt.

Bei einer anderen — aus der DE-33 01 286 A1 — bekannten Einrichtung ist der Zeitraum zwischen Entnahme einer Leiterplatte von einer Bauelemente-Bestückeinrichtung und dem erneuten Einbringen einer zu bearbeitenden Leiterplatte in die Bestückeinrichtung dadurch verringert, daß zwischen einem Magazin und der Bearbeitungseinrichtung eine Zuführbahn und in einer tiefer gelegenen Ebene parallel dazu eine Abführbahn eingefügt ist. Eine bearbeitete Leiterplatte wird von einer Beund Entladeposition auf die Abführbahn abgesenkt ; eine zu diesem Zeitpunkt bereits auf der Zuführbahn befindliche unbearbeitete nächste Leiterplatte wird umgehend auf die Beund Entladeposition überführt. Die Be- und Entladeposition ist integraler Bestandteil eines Drehtellers, der auf einem horizontal in zwei zueinander senkrechten Richtungen verfahrbaren Tisch gelagert ist. Nach der Beendigung der Bestückung einer Leiterplatte muß der Drehteller von einem Bestückkopf zum Ort der Zuführbahn verfahren und dort entladen und nachfolgend wieder beladen werden. Erst danach kann nach Überführen des Drehtellers in den Bereich des Bestückkopfes ein erneuter Bestückzyklus beginnen.

Die Erfindung geht von dieser bekannten Einrichtung aus und betrifft demgemäß eine Einrichtung zum Be- und Entladen von Bearbeitungseinrichtungen für Leiterplatten, insbesondere Bauelemente-Bestückeinrichtungen mit in einem Aufzug geführten Trägern, die parallele Einschubebenen für die Leiterplatten aufweisen und senkrecht zu den Einschubebenen derart verfahrbar sind, daß jede Einschubebene in die Flucht einer zwischen den Trägern und einer Be- und Entladeposition der Bearbeitungseinrichtung gelegenen Zuführbahn einfahrbar ist, auf die die Leiterplatten aus den Trägern und von der die Leiterplatten auf die Be- und Entladeposition mittels einer antreibbaren Überführvorrichtung überführbar sind, und mit einer bestückte Leiterplatten von der Be- und Entladeposition abnehmenden und deren Rückführung in die Träger einleitenden Rückführvorrichtung.

Die der Erfindung zugrunde liegende Aufgabe besteht darin, mit geringem apparativen Aufwand eine problemlose Anpassung an unterschiedlich gestaltete Be- und Entladepositionen der Bearbeitungseinrichtung und an unterschiedliche Leiterplattenformate zu ermöglichen ; zugleich soll, insbesondere für Bestückungsautomaten mit mehreren Bestückköpfen, die Möglichkeit geringerer Stillstandzeiten zwischen zwei Bestückzyklen geschaffen werden. Dies wird erfindungsgemäß derart erreicht, daß die Rückführvorrichtung derart ausgebildet und gesteuert ist, daß bestückte Leiterplatten von der Be- und Entladeposition aus der Ebene der Zuführbahn herausführbar und in dieser Lage in den Bereich zwischen den Trägern und der Beund Entladeposition hineinführbar und nach Fortführung einer auf der Zuführbahn zwischengespeicherten weiteren Leiterplatte auf der Zuführbahn absetzbar und von dort mittels einer antreibbaren Beschickungsvorrichtung in die Träger rückführbar sind.

Der wesentliche Vorteil der erfindungsgemäßen Einrichtung ist darin zu sehen, daß von der Bearbeitungseinrichtung zu bearbeitende Leiterplatten unmittelbar nach der Entfernung vorhergehend bearbeiteter Leiterplatten von der Beund Entladeposition der Bearbeitungseinrichtung auf diese überführt werden können, und daß die Rückführung der bearbeiteten oder komplettierten Leiterplatte in den Träger nicht über eine gesonderte Abführbahn, sondern über die Zuführbahn erfolgt.

Die im Rahmen der Erfindung eingesetzten Träger können in verschiedener Weise realisiert werden ; beispielsweise können die Träger als fest in den Aufzug integrierte Führungen ausgebildet sein, die jeweils paarweise eine Einschubebene bilden ; die Be- und Entladung der Träger kann dabei manuell oder maschinell erfolgen.

Eine bevorzugte Ausführungsform der erfindungsgemäßen Einrichtung, die insbesondere die Ein- und Ausschleusung von Leiterplatten in den bzw. aus dem Aufzug sowie den Transport der Leiterplatten zwischen verschiedenen Bearbeitungseinrichtungen erleichtert, sieht vor, daß die Träger als in den Aufzug einführbare und aus ihm herausführbare Magazine ausgebildet sind.

Eine weitere vorteilhafte Ausgestaltung der Erfindung sieht vor, daß der Träger derart verfahrbar ist, daß jede Leiterplatte nach ihrer Bearbeitung in die Einschubebene des Trägers rückgeführt wird, in der sie vor ihrer Überführung vom Träger auf die Zuführbahn gehalten ist. Durch diese Beibehaltung derselben Einschubebene für unbearbeitete Leiterplatten wird insbesondere die Steuerung von verketteten Fertigungsanlagen mit mehreren Bearbeitungseinrichtungen erleichtert, da während des Durchlaufs des Magazins durch mehrere Fertigungsstationen die für die einzelnen — häufig unterschiedlich ausgeprägten — Leiterplatten notwendigen Bearbeitungsoperationen bzw. die dazu notwendigen Steuerprogramme auf einfache Weise zugeordnet werden können.

Die Rückführung bearbeiteter Leiterplatten in dieselbe Einschubebene des Magazins wird steuerungstechnisch vorzugsweise derart durchgeführt, daß der Träger nach der Überführung einer Leiterplatte vom Träger auf die Zuführbahn um eine einem ganzzahligen Vielfachen des Abstands zweier benachbarter Einschubebenen entsprechende Strecke zurückverfahren und nach Aufnahme einer bearbeiteten Leiterplatte aus dieser Stellung um eine diese Strecke um den Abstand zweier benachbarter Einschubebenen übersteigende Strecke vorgefahren wird. Die Verfahrbewegung des Trägers ist also insgesamt pilgerschrittartig ausgeprägt, d. h., daß auf eine bestimmte Zahl von Vorwärtsschritten jeweils eine um « 1 » verringerte Zahl von Rückwärtsschritten folgt.

Vorzugsweise ist der Aufzug als Paternoster-Aufzug ausgebildet, da damit zeitverzögernde Rücksetzbewegungen zur Aufnahme neuer Magazine bzw. neuer Leiterplatten vermieden sind. Sofern die Träger als Magazine ausgebildet sind, wird vorgesehen, daß der Aufzug und das Magazin derart aufeinander abstimmt sind, daß zumindest zwei Magazine gleichzeitig übereinander im Aufzug geführt sind. Dadurch ergibt sich die Möglichkeit, bereits aus einem nachfolgenden Magazin zu bearbeitende Leiterplatten zu entnehmen, bevor das vorhergehende Magazin vollständig mit bearbeiteten Leiterplatten gefüllt ist. Eine Vereinfachung der Aufzugsteuerung und deren Synchronisierung mit der Steuerung für die Überführvorrichtung, die Rückführvorrichtung und die Beschickungsvorrichtung kann dabei dadurch erzielt werden, daß der Abstand benachbarter Einschubebenen zweier übereinander geführter Magazine ein ganzzahliges Vielfaches des Abstands benachbarter Einschubebenen innerhalb der Magazine beträgt. Insbesondere wenn dieses Vielfache « 1 » beträgt, die Abstände also identisch sind, entfällt jeder zusätzliche Steuerungsaufwand.

Eine funktionell besonders günstige Verknüpfung des Aufzugs mit anderen Bearbeitungseinrichtungen einer verketteten Fertigungsanlage wird dadurch erzielt, daß der Aufzug an zwei vertikal gegeneinander versetzte Förderbahnen angeschlossen ist, die auf der der Bearbeitungseinrichtung abgewandten Seite des Aufzugs angeordnet sind. In einer Ebene werden also Magazine an den Aufzug herangeführt, in einer anderen Ebene von ihm weggeführt, wobei eine weitgehende Unabhängigkeit von der Ausbildung und dem Aufstellungsort der Bearbeitungseinrichtungen besteht.

Eine vorteilhafte Weiterbildung der Erfindung dient dazu, die Magazine in eine durch die Lage und Wirkungsweise der Zuführbahn bzw. der Überführvorrichtung und der Beschickungsvorrichtung vorgegebene definierte Lage einzufahren. Dies wird dadurch erreicht, daß ortsfeste vertikale Führungen des Aufzugs und seitliche Führungskonturen des Magazins derart aufeinander abgestimmt sind, daß das Magazin exakt vertikal geführt ist. Die Lage des Magazins ist damit unabhängig von Querauslenkungen beweglicher Umlauforgane des Aufzugs. Die problemlose Einführung von Magazinen in den Aufzug bzw. Herausführung von Magazinen aus dem Aufzug wird dadurch ermöglicht, daß die vertikalen Führungen an der den Magazinförderbahnen zugewandten Seite des Aufzugs in einem zumindest in der Ebene der Förderbahnen einsetzenden und wenigstens eine der Höhe des Magazins entsprechende vertikale Abmessung aufweisenden Bereich unterbrochen sind. In diesem Bereich erfolgt die Einschleusung und Ausschleusung der Magazine in den bzw. aus dem Aufzug, während in dem dazwischen liegenden Bereich, in dem Leiterplatten aus dem Magazin entnommen und wieder in das Magazin zurückgeführt werden, eine exakte Ausrichtung des Magazins durch die vertikalen Führungen besteht.

Die einwandfreie Mitnahme der Magazine bzw. deren exakte Ausrichtung wird dadurch gefördert, daß an Umlaufelementen des Aufzugs befestigte horizontale Tragelemente derart ausgebildet und angeordnet sind, daß das Magazin bei seiner Einführung in den Aufzug mit horizontalen Führungskonturen an einer seiner beiden seitlichen Randebenen an den Tragelementen anliegt. Bei der Einführung der Magazine in den Aufzugsbereich laufen also die seitlichen horizontalen Führungskonturen auf die Tragelemente auf, womit eine definierte Lage der Magazine im Aufzug gewährleistet ist. Als besonders vorteilhaft ist in diesem Zusammenhang anzusehen, daß die Führungskonturen als im Randbereich des Magazins gelegene Nut ausgebildet sind. Die Einführung der Magazine in den Aufzug bzw. ihre Ausschleusung aus dem Aufzug wird vorteilhafterweise derart bewerkstelligt, daß die Förderbahnen mit Mitnahmeelementen an den vertikalen Führungskonturen des mit seinen horizontalen Führungskonturen in einer Horizontalführungsbahn laufenden Magazins angreifen. Sowohl auf den Förderbahnen als auch innerhalb des Aufzugs ist damit das Magazin an einer seitlichen Ebene gehalten, so daß die vorderen und hinteren Stirnkanten der Leiterplatten frei sind ; damit ist eine weitestgehende Freizügigkeit in der konstruktiven Ausgestaltung und örtlichen Anbringung der dem Ausschleusen und Einführen von Leiterplatten aus dem bzw. in das Magazin dienenden angetriebenen Vorrichtungen ermöglicht.

Die auch durch Transportvorgänge nicht beeinflußbare exakte relative Lage zwischen den Einschubebenen des Magazins und den in ihn gehaltenen Leiterplatten einerseits und die unbehinderte Überführung von Leiterplatten zwischen Aufzug und Bearbeitungseinrichtung andererseits wird gemäß einer vorteilhaften Weiterbildung der Erfindung dadurch sichergestellt, daß jeder Einschubebene der Magazine zur selbsttätigen Lagesicherung einer eingeschobenen Leiterplatten ein separates Sicherungsorgan zugeordnet ist, das durch ein Betätigungselement in Höhe der Zuführbahn lösbar ist. Die konstruktive Realisierung bzw. die Details des Magazins können insbesondere entsprechend dem in der deutschen Patentanmeldung P 33 24 561 beschriebenen Magazin ausgestaltet sein.

Die einseitige seitliche Arretierung der Magazine im Aufzug schafft die Möglichkeit, ohne apparative oder steuerungstechnische Anpassungen unterschiedliche Formate von Leiterplatten und damit Magazine unterschiedlicher Abmessungen zu befördern ; auch eine Anpassung der Förderbahnen kann damit unterbleiben.

Ebenfalls der Anpassung der erfindungsgemäßen Einrichtung an unterschiedliche Formate von Leiterplatten dient eine vorteilhafte Weiterbildung der Erfindung, gemäß der die Zuführbahn zwei Führelemente aufweist, deren Abstand in Anpassung an unterschiedliche Formate der Leiterplatten verstellbar ist.

Gemäß einer vorteilhaften Weiterbildung der Erfindung werden die beiden Verfahrrichtungen der Leiterplatten auf der Zuführbahn konstruktiv derart realisiert, daß die die Leiterplatten von der Zuführbahn auf die Be- und Entladeposition überführende antreibbare Überführvorrichtung als die die zwischengespeicherten bestückten Leiterplatten in den Träger (Magazin) rückführende Beschickungsvorrichtung dient. Diese Realisierung erfolgt vorzugsweise derart, daß die Überführvorrichtung und die Beschickungsvorrichtung einen im Bereich der Zuführbahn verfahrbaren Schieber aufweisen. Bezüglich der Ausbildung des Schiebers sieht eine weitere Ausgestaltung der Erfindung vor, daß der Schieber zwei in Längsrichtung der Zuführbahn gegeneinander versetzte Mitnahmeelemente aufweist, die wahlweise derart aus der Verschiebeebene der Leiterplatten herausbewegbar bzw. in diese hereinbewegbar sind, daß die Verschiebung der Leiterplatten in die Be- und Entladeposition der Bearbeitungseinrichtung mittels der bearbeitungseinrichtungsnäheren und in den Träger mittels des trägernäheren Mitnahmeelements erfolgt. Diese Ausbildung des Schiebers eröffnet die Möglichkeit, daß das trägernähere Mitnahmeelement in einer be- und entladepositionsnahen Verfahrstellung als Anschlag für aus dem Träger auf die Zuführbahn aufgeschobene Leiterplatten dient. Damit ist sichergestellt, daß alle aus dem Träger auf die Zuführbahn überführten Leiterplatten in einer definierten Lage auf der Zuführbahn gehalten sind.

Das nachfolgende Heranführen des be- und entladepositionsnäheren Mitnahmeelements an die dem Träger zugewandte Randkante der Leiterplatte wird dadurch ermöglicht, daß das beund entladepositionsnahe Mitnahmeelement und das trägernahe Mitnahmeelement aus der Verschiebeebene der Leiterplatten herausbewegbar sind. Damit wird eine Verschiebung der auf der Zuführbahn ruhenden Leiterplatte während des Verfahrens des be- und entladepositionsnäheren Mitnahmeelementes an die trägernähere Randkante der Leiterplatte vermieden.

Wenn das trägernähere Mitnahmeelement in seiner Funktion als Anschlag oder zur nachfolgenden Verschiebung einer Leiterplatte in den Träger in eine be- und entladepositionsnahe Stellung eingefahren ist, befindet sich das be- und entladepositionsnahe Mitnahmeelement bereits im Bereich der Be- und Entladeposition. Um ein Kollidieren dieses Mitnahmeelementes mit bestimmten konstruktiven Bestandteilen der Be- und Entladeposition zu vermeiden, sieht eine vorteilhafte Weiterbildung der Erfindung vor, daß das be- und entladepositionsnähere Mitnahmeelement unabhängig vom magazinnäheren Mitnahmeelement aus der Verschiebeebene der Leiterplatte herausbewegbar ist.

Eine weitere vorteilhafte Ausgestaltung der Erfindung bezweckt die optimale Anpassung an eine Bearbeitungseinrichtung, die als Bestückeinrichtung mit mehreren Bestückköpfen ausgebildet ist. Bei der aus der DE-33 01 286 A1 bekannten Einrichtung erfolgt die Anpassung an eine Bestückeinrichtung mit zwei Bestückköpfen durch eine Verdoppelung aller dem Be- und Entladen der Bestückeinrichtung dienenden Funktionselemente ; zwei identische Be- und Entladeeinrichtungen sind an zwei verschiedenen Seiten der Bestückeinrichtung angeordnet. Die Ausgestaltung der Erfindung löst die Aufgabe, auch eine größere Zahl von Bestückköpfen auf apparativ einfache Weise mit zu bestückenden Leiterplatten zu versorgen und dabei die Möglichkeit optimal kurzer Arbeitspausen der Bestückköpfe während des Leiterplattenwechsels vorzusehen, durch die Kombination folgender Merkmale :

a) « m » Aufzüge sind « n » nebeneinander angeordneten Zuführbahnen zugeordnet,

b) die Überführvorrichtung und die Rückführvorrichtung sind zu einer Be- und Entladevorrichtung zusammengefaßt,

b1) die Be- und Entladevorrichtung weist « 2n » nebeneinander gelegene Arretierungsvorrichtungen auf,

c) der Mittenabstand benachbarter Zuführbahnen entspricht dem Mittenabstand benachbarter Be- und Entladepositionen der Bestückeinrichtung und dem doppelten Mittenabstand benachbarter Arretierungsvorrichtungen,

d) die Be- und Entladevorrichtung ist im Sinne der mittels der Arretierungsvorrichtungen durchführbaren Aufnahme unbestückter Leiterplatten an der Zuführbahn bzw. der Abgabe unbestückter und der Aufnahme bestückter Leiterplatten den Be- und Entladepositionen vertikal verstellbar.

Dabei gilt : $1 \leq m \leq n$ ; $n = z \cdot m$, $z = 1, 2, 3...$

Die Be- und Entladevorrichtung kann demgemäß eine gegenüber der Zahl der Bestückköpfe doppelte Zahl von Leiterplatten gleichzeitig aufnehmen, wodurch die Möglichkeit geschaffen ist, nach Abnahme einer bestückten Leiterplatte von einer Be- und Entladeposition und einer lediglich dem halben Abstand zweier benachbarter Be- und Entladepositionen entsprechenden Verfahrstrecke der Be- und Entladevorrichtung eine unbestückte Leiterplatte auf derselben Be- und Entladeposition abzulegen.

Eine Verringerung des apparativen Aufwands ist insbesondere durch eine Verringerung der Zahl der Aufzüge möglich. Dies wird in vorteilhafter Weise dadurch erzielt, daß die « n » Zuführbahnen auf einem Tragrahmen gelagert sind, der um eine wenigstens dem Mittenabstand benachbarter Zuführbahnen entsprechende Strecke in Überführ- bzw. in Rückführrichtung verfahrbar ist. Es können also mehrere (z m) Bestückköpfe mit einer kleineren Zahl (m) von Aufzügen versorgt werden. Anzustreben ist es im allgemeinen, nur einen einzigen (m = 1) Aufzug vorzusehen.

Mehrere Aufzüge (m > 1) bieten dagegen die Möglichkeit, die Verteilung der bearbeiteten, insbesondere bestückten, Leiterplatten auf die Träger bzw. Magazine der verschiedenen Aufzüge gegenüber der Verteilung der unbearbeiteten Leiterplatten relativ freizügig zu verändern. Diese Änderung der Verteilung kann nach den unterschiedlichsten Kriterien erfolgen ; beispielsweise können als fehlerhaft erkannte Leiterplatten jeweils einem der « m » Aufzüge zugeführt werden. Es ist auch möglich, alle Leiterplatten eines Magazins nach ihrer Bearbeitung in ein anderes Magazin einzufügen. Eine weitere Anwendungsmöglichkeit sieht beispielsweise vor, ein Magazin mit eng gestapelten unbestückten Leiterplatten und ein zweites leeres Magazin in zwei unterschiedlichen Aufzügen einzusetzen ; die Rückführung der bestückten Leiterplatten erfolgt dann je zur Hälfte in beide Magazine.

Besonders günstige Be- und Entlademöglichkeiten sind dann gegeben, wenn die Überführvorrichtung und die Rückführvorrichtung bzw. Be- und Entladevorrichtung senkrecht zur Überführrichtung zwischen den Zuführbahnen und den Be- und Entladepositionen horizontal verstellbar ist. Neben dem Vorteil kurzer Verfahrwege besteht bei Bestückeinrichtungen, die für jeden Bestückkopf zwei Be- und Entladepositionen aufweisen, die Möglichkeit, Stillstandzeiten des Bestückkopfes während der Be- und Entladung von Leiterplatten völlig oder zumindest annähernd völlig zu vermeiden. Die Be- und Entladevorrichtung fährt hierzu in eine bestimmte Lage, in der eine bestückte Leiterplatte von der einen Be- und Entladeposition entnommen werden kann ; in dieser befindet sich die zweite Be- und Entladeposition unterhalb des Bestückkopfes. Während des Einbringens eines Bauelementes auf die gerade zu bestückende Leiterplatte erfolgt die Entnahme der bereits bestückten Leiterplatte von der anderen Be- und Entladeposition. In der gleichen Weise erfolgt die Übergabe der nächsten zu bestückenden Leiterplatte an die nunmehr freie Be- und Entladeposition.

Für den Fall, daß die Entnahme von der bzw. die Übergabe an die Be- und Entladeposition länger dauert als das Einbringen eines Bauelementes auf die Leiterplatte kann die Stillstandzeit der horizontal verschiebbaren Arbeitsplatte der Bestückeinrichtung bei diesem Arbeitsschritt entsprechend verlängert werden. Auch diese Verlängerung kann vermieden werden, wenn die Überführvorrichtung und die Rückführvorrichtung bzw. die Be- und Entladevorrichtung mittels eines schaltbaren Kupplungselements an eine die Be- und Entladepositionen aufnehmende Tragplatte der Bearbeitungseinrichtung anschließbar ist. Da auf diese Weise Synchronität der Bewegungen erzielt ist, kann nicht nur während des eigentlichen Bestückvorgangs, sondern auch während des Verfahrens der Arbeitsplatte eine Übergabe an die bzw. Abnahme von der Be- und Entladeposition erfolgen. Diese konstruktive Realisierung dieser Ankopplung kann beispielsweise durch einen Kupplungsbolzen erfolgen, der mittels eines vorzugsweise pneumatischen Antriebs wahlweise in die Kupplungsstellung einfahrbar ist.

Die Verfahrbarkeit der Überführvorrichtung und der Rückführvorrichtung bzw. der Be- und Entladevorrichtung in zwei zueinander senkrechten Richtungen kann beispielsweise durch eine einem Portalkran ähnliche Verfahrvorrichtung erzielt werden. Die An- bzw. Abkopplung der Leiterplatten an die bzw. von der Be- und Entladevorrichtung kann mittels für diesen Zweck bekannter Arretierungselemente, beispielsweise pneumatisch angetriebene Klemmzangen, erfolgen.

Gemäß einer vorteilhaften Weiterbildung der Erfindung ist vorgesehen, daß der Abstand der Arretierungselemente in Anpassung an unterschiedliche Formate der Leiterplatten verstellbar ist.

Für die Ausgestaltung der Erfindung, bei der die Überführvorrichtung und die Rückführvorrichtung separate Bauteile sind, besteht eine vorteilhafte Realisierung der Arretierungselemente darin, daß die Arretierungselemente als federnd an den zugeordneten Randebenen der Leiterplatten anliegende Klemmelemente ausgebildet sind. Diese Ausbildung bietet die Möglichkeit, den Antrieb für die Klemmelemente aus der Verfahrbewegung der Rückführvorrichtung abzuleiten. Dies kann beispielsweise derart erfolgen, daß im Bereich der Zuführbahn und der Be- und Entladeposition der Bearbeitungseinrichtung Führungsflächen angeordnet sind, die bei Annäherung der Rückführvorrichtung die Klemmelemente gegen die Federkraft von den zugewandten Randebenen der Leiterplatten abklappen. Da im Bereich der Be- und Entladeposition die Leiterplatten erfaßt und mitgenommen werden müssen, dienen hier vorzugsweise die entsprechenden Stirnflächen der Leiterplatten als Führungsflächen.

Bezüglich der Antriebe der bewegbaren Teile der erfindungsgemäßen Einrichtung ist vorgesehen, daß die Antriebe der Überführvorrichtung und der Rückführvorrichtung mittels Pneumatikzylinder realisiert sind.

Die Erfindung wird im folgenden anhand eines in 6 Figuren dargestellten Ausführungsbeispiels erläutert.

Figur 1 zeigt in schematischer Darstellung eine Einrichtung zum Überführen von Leiterplatten zwischen einem Aufzug und einer ebenfalls nur schematisch angedeuteten Leiterplatten-Bestückeinrichtung.

In Figur 2 ist die in Figur 1 teilweise verdeckte Einrichtung zum Überführen von Leiterplatten zwischen dem Aufzug und einer Leiterplatten-Bestückeinrichtung in einer Prinzipdarstellung gezeigt.

In den Figuren 3 bis 5 sind wesentliche Bestandteile der in den Figuren 1 und 2 gezeigten Einrichtungen detailliert dargestellt.

Die Figur 6 zeigt in einer schematischen Darstellung eine Beund Entladevorrichtung für eine Bestückeinrichtung mit zwei Bestückköpfen.

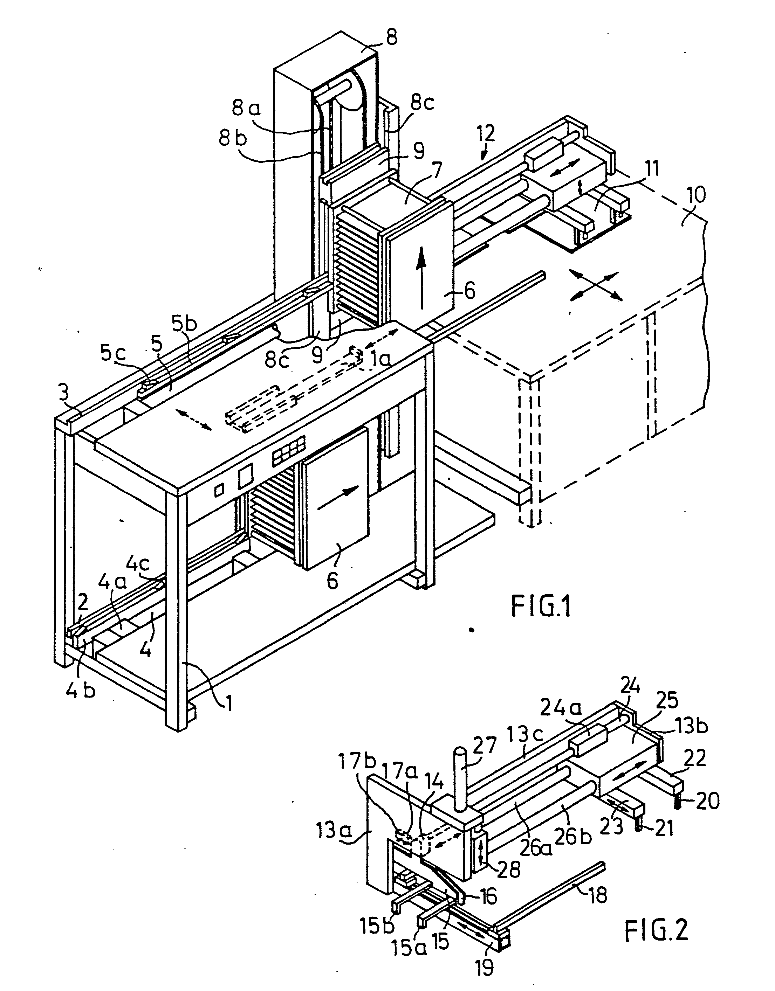

In der in Figur 1 dargestellten Fertigungseinrichtung sind auf einem Tisch 1 zwei Förderbahnen angeordnet, die im wesentlichen aus je einer Führungsleiste 2, 3 und je einem doppeltwirkenden pneumatischen Zylinder 4, 5 bestehen, an dessen Außenläufer 4a eine Tragstange 4b, 5b mit Mitnahmeelementen 4c, 5c befestigt ist. Die Mitnahmeelemente 4c, 5c sind derart kippbar gelagert, daß sie in ihrer Normalstellung über die Tragstange 4b, 5b hinausragen ; dadurch werden Magazine 6, die mit einer seitlichen horizontalen Nut in den Führungsleisten 2, 3 geführt sind, transportiert. Wird der Außenläufer 4a in entgegengesetzter Richtung zurückgeschaltet, so werden die Mitnahmeelemente 4c, 5c durch Einwirken des vertikalen Randbereichs des Magazins 6 nach unten geklappt ; eine Mitnahme des Magazins 6 ist damit verhindert.

Die Förderbahnen 2, 3 ; 4, 5 können mit — nicht dargestellten — weiteren Fördereinrichtungen zusammenarbeiten, die an die linke Begrenzungsebene des Tisches 1 anschließen. Von der Förderbahn 2, 4 aufgenommene Magazine 6 mit in ihnen befindlichen Leiterplatten 7 werden im Endbereich des Tisches 1 in den Wirkungsbereich eines Paternosteraufzugs 8 eingeführt, der an Ketten 8a, 8b angeordnete Tragelemente 9 aufweist, die in die seitlichen horizontalen Nuten der Magazine 6 eingreifen. Durch dem Paternosteraufzug 8 zugeordnete seitliche Führungen 8c, die in vertikale Längsnuten der Magazine 6 eingreifen, wird das Magazin 6 in definierter Lage innerhalb des Bereichs des Paternosteraufzugs 8 gehalten und gefördert.

Eins der Magazine 6 ist in einer Lage dargestellt, in der aus dem Magazin 6 Leiterplatten 7 entnommen und an eine nur schematisch angedeutete Bestückeinrichtung mit einer in zwei zueinander senkrechten Richtungen horizontal verstellbaren Trägerplatte 10 abgegeben werden, auf der eine Be- und Entladeposition 11 angebracht ist und über der ein — nicht dargestellter — Bestückkopf angeordnet ist. Die Überführung von Leiterplatten 7 zwischen der Tragplatte 10 und dem Magazin 6 erfolgt mit Hilfe einer Einrichtung 12, deren Ausbildung prinzipiell aus Figur 2 ersichtlich ist.

Die in Figur 2 schematisch dargestellte Einrichtung 12 beinhaltet einen Tragrahmen mit einer vorderen und einer hinteren Stirnplatte 13a, 13b sowie einem diese verbindenden Steg 13c. Im Tragrahmen ist unter anderem ein Pneumatik-Zylinder 14 zum Antrieb einer Überführvorrichtung gelagert ; die Überführvorrichtung weist in ihrem dem in Figur 2 nicht dargestellten Magazin zugewandten vorderen Bereich zwei verschwenkbare Hebel 15, 16 auf.

Zwei weitere Pneumatik-Zylinder 17a, 17b, die ebenfalls in der vorderen Stirnplatte 13a gelagert sind, wirken auf die Hebel 15, 16 derart ein, daß bei Aktivierung beider Pneumatik-Zylinder 17a, 17b die Hebel 15, 16 nach oben geschwenkt und so über eine Leiterplatte hinweggeführt werden.

Die Leiterplatten werden auf der Zuführbahn abgelegt, die durch zwei Speicherschienen, von denen nur eine, 18, sichtbar ist und einen Halter 19 für die Speicherschienen 18 gebildet wird.

Die Rückführung von Leiterplatten, die innerhalb einer Bestück-einrichtung behandelt worden sind, in das Magazin erfolgt mittels zweier Paare von Klemmelementen, von denen jeweils nur eins 20, 21, sichtbar ist ; die Klemmelemente 20, 21 sind jeweils im Endbereich von Haltern 22, 23 befestigt, wobei die Halter 22, 23 verstellbar angeordnet sind, so daß die Klemmelemente 20, 21 an unterschiedliche Leiterplattenformate anpaßbar sind. Das gleiche gilt für den Speicherschienenträger 19 und die Speicherschiene 18.

Der Antrieb der Rückführvorrichtung erfolgt mittels eines weiteren Pneumatik-Zylinders 24, dessen Außenläufer 24a einen Rückführschlitten 25 trägt, der zwischen den Stirnplatten 13a, 13b auf Säulenführungen verfahrbar ist. Das Ausfahren von durch die Klemmelemente 20, 21 gehaltenen — nicht dargestellten — Leiterplatten aus der Ebene von auf der Speicherschiene 18 aufliegenden anderen Leiterplatten erfolgt mittels eines weiteren Pneumatik-Zylinders 27, mit dessen Hilfe ein Trägerschlitten 28 verfahrbar ist, der den Steg 13c trägt und damit indirekt die Verbindung der hinteren Stirnplatte 13b mit der vorderen Stirnplatte 13a herstellt.

Bei der Abwärtsbewegung der Rückführvorrichtung werden in Richtung auf die Leiterplatten abgeschrägte Konturen der Klemmelemente 20, 21 entweder durch die Leiterplattenaußenkante im Bereich der Bestückeinrichtung oder durch die Außenkante der Speicherschiene 18 im Bereich der Zuführbahn ausgelenkt, wodurch ein Eingreifen bzw. Lösen der Klemmung hervorgerufen wird.

Im folgenden wird, bezugnehmend auf die Figuren 1 und 2 ein Be- und Entladevorgang im einzelnen erläutert.

Das Magazin 6 wird mittels der Ketten 8a, 8b des Paternosteraufzugs 8 in eine Lage gefahren, in der die nächste in die Bestückeinrichtung zu überführende Leiterplatte 7 in die Ebene der Zuführbahn 18 eingefahren ist. Im beschriebenen Beispiel wird davon ausgegangen, daß vorangehend bereits eine bearbeitete Leiterplatte in das Magazin 6 zurückgeführt worden ist. Ein am Fördertisch 1 angeordneter Schieber 1a schiebt nun die ausgewählte Leiterplatte auf die Speicherschiene 18 bis zu einem Anschlag, der durch die Vorderkante von am Hebel 15 angeordneten Mitnahmeelementen 15a, 15b in deren in die Be- und Entladeposition eingefahrenen Stellung gebildet ist ; anschließend wird der Schieber 1a wieder zurückgeschoben. Die Druckluftzylinder 17a, 17b werden nunmehr eingeschaltet und üben ein Drehmoment auf die schwenkbar gelagerten Hebel 15, 16 aus. Das nachfolgende Einfahren der Hebel 15, 16 in die in Figur 2 dargestellte Lage ist damit ohne Veränderung der Lage der eingeschobenen Leiterplatten 7 möglich.

Abhängig vom Arbeitszyklus der Bestückeinrichtung hat in der Zwischenzeit oder wird nachfolgend eine bearbeitete Leiterplatte von der Rückführvorrichtung übernommen, indem die Klemmelemente 20, 21 die Leiterplatte zwischen sich erfassen. Nachdem die Leiterplatte von den Klemmelementen 20, 21 übernommen worden ist, werden diese angehoben. Sofort nach dem Anheben ist ein Einschieben der auf den Speicherschienen 18 ruhenden nächsten unbearbeiteten Leiterplatte möglich. Dieses Einschieben erfolgt mit dem Hebel 16. Da sofort nach dem Anheben der Leiterplatte mittels der Klemmelemente 20, 21 das Einschieben der nächsten Leiterplatte erfolgt, sind die durch den. Be- und Entladevorgang hervorgerufene Stillstandzeiten der Bestückeinrichtung außerordentlich gering.

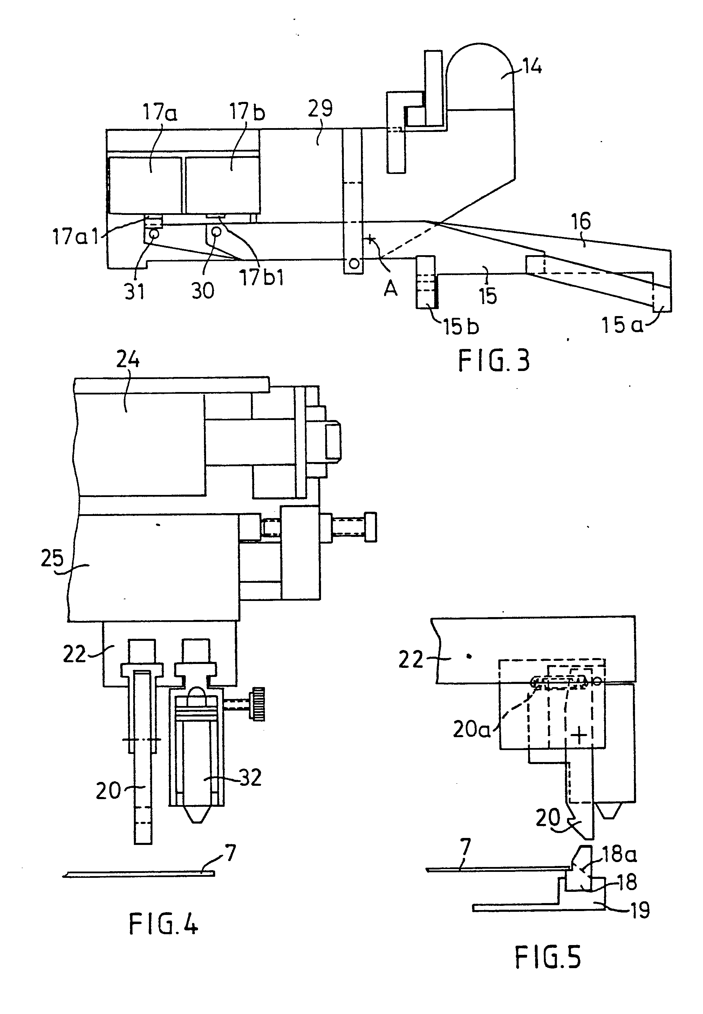

Die Figur 3 zeigt im wesentlichen eine bevorzugte konstruktive Ausführungsform der Hebel 15, 16. Beide Hebel 15, 16 sind auf einer gemeinsamen Achse A — nur schematisch angedeutet — drehbar gelagert und tragen Ansätze 30, 31, auf die bei Aktivieren der Pneumatik-Zylinder 17a, 17b deren Kolbenstößel 17a1, 17b1 im Sinne einer Verschwenkung der Hebel 15, 16 abgesenkt werden. Die Befestigung und Lagerung der Hebel 15, 16, der Pneumatik-Zylinder 17a, 17b sowie des dem Antrieb der Hebel 15, 16 dienenden Pneumatik-Zylinders 14 erfolgt mittels einer Tragplatte 29.

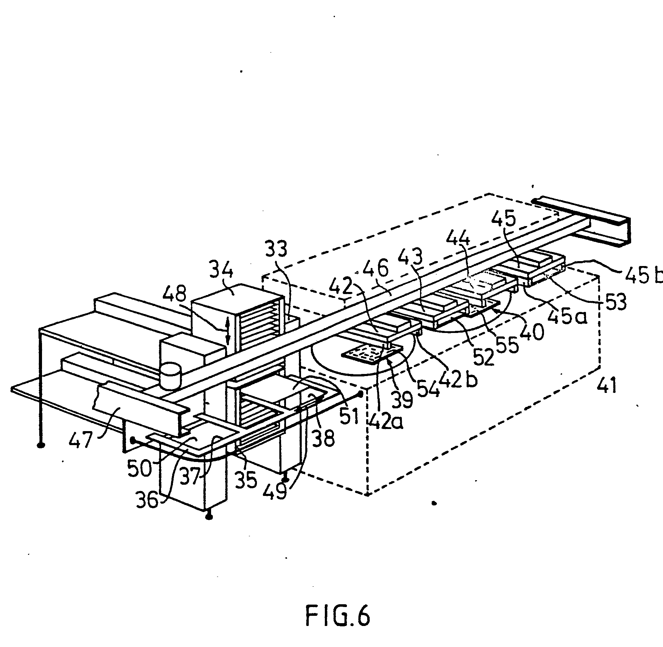

In den Figuren 4 und 5 ist in zwei Ansichten ein Teil der Rückführvorrichtung im Bereich der Zuführbahn dargestellt. Der mit dem nicht sichtbaren Außenläufer des Pneumatik-Zylinder 24 verbundene Rückführschlitten 25 trägt den Halter 22, in dessen Endbereich das Klemmelement 20 gegen die Kraft einer Feder 20a verschwenkbar gelagert ist. Bei Absenken des Halters 22 trifft die abgeschrägte vordere Kante des Klemmelementes 20 auf eine schräge Führungskante 18a der Speicherschiene 18, die im Speicherschienenträger 19 gelagert ist. Die vom Klemmelement 20 gehaltene Leiterplatte 7 wird damit freigegeben. Der Halter 22 trägt ebenso wie der nicht dargestellte Halter 23 einen Stößel 32, der pneumatisch auslenkbar ist und in dieser Auslenkstellung Hebel, die Zentrierstifte für die exakte Ausrichtung der Leiterplatte 7 im Bereich der Be- und Entladeposition tragen, im Sinne der Freigabe der Leiterplatte 7 verschwenken.

Die in der Figur 6 dargestellte Einrichtung zum Be- und Entladen einer Bestückeinrichtung für Leiterplatten weist im wesentlichen einen Aufzug 33 auf, in dem Magazine 34, 35 geführt sind. Dem Aufzug 33 ist ein Tragrahmen 36 zugeordnet, auf dem zwei Zuführbahnen 37, 38 gebildet sind ; der Mittenabstand der beiden Zuführbahnen 37, 38 entspricht dem Mittenabstand zweier Be- und Entladepositionen 39, 40 einer Leiterplatten-Bestückeinrichtung 41.

Die Versorgung der Be- und Entladepositionen 39, 40 erfolgt mittels einer Be- und Entladevorrichtung, die vier Arretierungsvorrichtungen 42 bis 45 aufweist, die jeweils zwei parallele pneumatisch verstellbare Klemmleisten 42a, 42b bis 45a, 45b aufweisen.

Die Arretierungsvorrichtungen 42... 45 sind entlang einer ersten Tragschiene 46 verfahrbar, die ihrerseits innerhalb einer Tragschiene 47 verfahrbar ist. Die vertikale Auslenkung der Arretierungsvorrichtungen 42... 45 erfolgt in nicht dargestellter Weise pneumatisch. Ebenfalls nur schematisch ist die Verfahrrichtung innerhalb des Aufzugs 33 und die Verfahrrichtung des Tragrahmens 36 mittels Pfeilen 48, 49 angedeutet.

Zur Verdeutlichung der Arbeitsweise der dargestellten Einrichtung ist eine bestimmte Betriebsphase angedeutet, in der zwei Leiterplatten 50, 51 aus dem Magazin 35 entnommen sind. Die Zuführbahn 37 hat sich dazu in der der dargestellten Betriebsphase vorangehenden Phase in Flucht zum Magazin 35 befunden und die Leiterplatte 50 übernommen ; anschließend wird die Leiterplatte 51 auf die Zuführbahn 38 übergeben.

Mittels der Arretierungsvorrichtungen 43 und 45 sind zwei bereits bestückte — durch Schraffur angedeutet — Leiterplatten 52, 53 von den Be- und Entladepositionen 39, 40 übernommen worden. Nach Verfahren der Arretierungsvorrichtungen 42... 45 befinden sich diese in der dargestellten Lage und zwei unbestückte Leiterplatten 54, 55 können auf die nunmehr freigewordenen Be- und Entladepositionen 39, 40 überführt werden. Anschließend werden die Arretierungsvorrichtungen 42... 45 in Richtung auf den Aufzug 33 in eine Position verfahren, in der die beiden Leiterplatten 50, 51 von den Zuführbahnen 37, 38 mittels der Arretierungsvorrichtungen 42, 44 übernommen werden können. Durch anschließendes weiteres Verfahren in die gleiche Richtung gelangen die Arretierungsvorrichtungen 43 und 45 in den Bereich der Zuführbahnen 37, 38 und die bestückten Leiterplatten 52, 53 werden an die entsprechenden Zuführbahnen übergeben. Die Arretierungsvorrichtungen 42...45 fahren anschließend in den Bereich der Bestückeinrichtung 41 zurück, während der Tragrahmen 36 so verfahren wird, daß zunächst die bestückte Leiterplatte 53 und anschließend die bestückte Leiterplatte 52 in das Magazin 35 übernommen bzw. neue unbestückte Leiterplatten aus dem Magazin 35 auf die Zuführbahnen 37, 38 überführt werden.

**Patentansprüche**

1. Einrichtung zum Be- und Entladen von Bearbeitungseinrichtungen für Leiterplatten, insbesondere Bauelemente-Bestückeinrichtungen mit in einem Aufzug geführten Trägern, die parallele Einschubebenen für die Leiterplatten aufweisen und senkrecht zu den Einschubebenen derart verfahrbar sind, daß jede Einschubebene in die Flucht einer zwischen den Trägern und einer Be- und Entladeposition der Bearbeitungseinrichtung gelegenen Zuführbahn einfahrbar ist, auf die die Leiterplatten aus den Trägern und von der die Leiterplatten auf die Be- und Entladeposition mittels einer antreibbaren Überführvorrichtung überführbar sind, und mit einer bestückte Leiterplatten von der Be- und Entladeposition abnehmenden und deren Rückführung in die Träger einleitenden Rückführvorrichtung, dadurch gekennzeichnet, daß die Rückführvorrichtung (20 bis 28) derart ausgebildet und gesteuert ist, daß bearbeitete Leiterplatten von der Be- und Entladeposition (11) aus der Ebene der Zuführbahn (18) herausführbar und in dieser Lage in den Bereich zwischen den Trägern und der Be- und Entladeposition (11) hineinführbar und nach der Fortführung einer auf der Zuführbahn (18) zwischengespeicherten weiteren Leiterplatte auf der Zuführbahn (18) absetzbar und von dort mittels einer antreibbaren Beschickungsvorrichtung (15) in die Träger rückführbar sind.

2. Einrichtung nach Anspruch 1, dadurch gekennzeichnet, daß die Träger als in den Aufzug (8), einführbare und aus ihm herausführbare Magazine (6) ausgebildet sind.

3. Einrichtung nach Anspruch 1 oder 2, dadurch gekennzeichnet, daß der Träger oder das Magazin (6) derart verfahrbar ist, daß jede Leiterplatte (7) nach ihrer Bearbeitung in die Einschubebene des Trägers oder des Magazins (6) rückgeführt wird, in der sie vor ihrer Überführung vom Träger oder Magazin (6) auf die Zuführbahn (18) gehalten ist.

4. Einrichtung nach Anspruch 3, dadurch gekennzeichnet, daß der Träger oder das Magazin (6) nach der Überführung einer Leiterplatte (7) vom Träger oder vom Magazin (6) auf die Zuführbahn (18) um eine einem ganzzahligen Vielfachen des Abstands zweier benachbarter Einschubebenen entsprechende Strecke zurückverfahren und nach Aufnahme einer bearbeiteten Leiterplatte aus dieser Stellung um eine diese Strecke um den Abstand zweier benachbarter Einschubebenen übersteigende Strecke vorgefahren wird.

5. Einrichtung nach einem der Ansprüche 1 bis 4, dadurch gekennzeichnet, daß der Aufzug (8) als Paternoster-Aufzug ausgebildet ist.

6. Einrichtung nach Anspruch 5, dadurch gekennzeichnet, daß der Aufzug (8) und das Magazin (6) derart aufeinander abgestimmt sind, daß zumindest zwei Magazine (6) gleichzeitig übereinander im Aufzug (8) geführt sind.

7. Einrichtung nach Anspruch 6, dadurch gekennzeichnet, daß der Abstand benachbarter Einschubebenen zweier übereinander geführter Magazine (6) ein ganzzahliges Vielfaches, vorzugsweise « 1 », des Abstands benachbarter Einschubebenen innerhalb der Magazine (6) beträgt.

8. Einrichtung nach einem der Ansprüche 5 bis 7, dadurch gekennzeichnet, daß der Aufzug (8) an zwei vertikal gegeneinander versetzte Förderbahnen (2, 3) angeschlossen ist, die auf der der Bearbeitungseinrichtung (10) abgewandten Seite des Aufzugs (8) angeordnet sind.

9. Einrichtung nach einem der Ansprüche 2 bis 8, dadurch gekennzeichnet, daß ortsfeste vertikale Führungen (8c) des Aufzugs (8) und seitliche Führungskonturen des Magazins (6) derart aufeinander abgestimmt sind, daß das Magazin (6) exakt vertikal geführt ist.

10. Einrichtung nach Anspruch 8, dadurch gekennzeichnet, daß die vertikalen Führungen (8c) an der den Förderbahnen (2, 3) zugewandten Seite des Aufzugs (8) in einem zumindest in der Ebene der Förderbahnen (2, 3) einsetzenden und wenigstens eine der Höhe des Magazins (6) entsprechende vertikale Abmessung aufweisenden Bereich unterbrochen sind.

11. Einrichtung nach Anspruch 9 oder 10, dadurch gekennzeichnet, daß an Umlaufelementen (8a, 8b) des Aufzugs (8) befestigte horizontale Tragelemente (9) derart ausgebildet und angeordnet sind, daß das Magazin (6) bei seiner Einführung in den Aufzug (8) mit horizontalen Führungskonturen an einer seiner beiden seitlichen Randebenen auf den Tragelementen (9) aufliegt.

12. Einrichtung nach einem der Ansprüche 2 bis 11, dadurch gekennzeichnet, daß jeder Einschubebene der Magazine (6) zur selbsttätigen Lagesicherung einer eingeschobenen Leiterplatte ein separates Sicherungsorgan zugeordnet ist, das durch ein Betätigungselement in Höhe der Zuführbahn lösbar ist.

13. Einrichtung nach einem der Ansprüche 1 bis 12, dadurch gekennzeichnet, daß die die Leiterplatten (7) von der Zuführbahn (18) auf die Be- und Entladeposition überführende antreibbare Überführvorrichtung (15, 16) als die die zwischengespeicherten bestückten Leiterplatten in den Träger oder das Magazin (6) rückführende Beschickungsvorrichtung dient.

14. Einrichtung nach Anspruch 13, dadurch gekennzeichnet, daß die Überführvorrichtung und die Beschickungsvorrichtung einen im Bereich der Zuführbahn (18) verfahrbaren Schieber mit zwei Hebeln (15, 16) aufweisen.

15. Einrichtung nach Anspruch 14, dadurch gekennzeichnet, daß der Schieber zwei in Längsrichtung der Zuführbahn (14) gegeneinander versetzte Mitnahmeelemete (15a, 15b ; 16) aufweist, die wahlweise derart aus der Ebene der Zuführbahn herausbewegbar bzw. in diese hineinbewegbar sind, daß die Verschiebung der Leiterplatten (7) in die Be- und Entladeposition der Bearbeitungseinrichtung (10) mittels des bearbeitungseinrichtungsnäheren (16) und in den Träger oder das Magazin (6) mittels der trägernäheren Mitnahmeelemente (15a, 15b) erfolgt.

16. Einrichtung nach Anspruch 15, dadurch gekennzeichnet, daß die trägernäheren Mitnahmeelemente (15a, 15b) in einer be- und entladepositionsnahen Verfahrstellung als Anschlag für aus dem Träger oder dem Magazin (6) in die Zuführbahn (18) eingeschobene Leiterplatten (7) dient.

17. Einrichtung nach Anspruch 15 oder 16, dadurch gekennzeichnet, daß das be- und entladepositionsnähere Mitnahmeelement (16) und die trägernahen Mitnahmeelemente (15a, 15b) aus der Verschiebeebene der Leiterplatten (7) herausbewegbar ist.

18. Einrichtung nach Anspruch 16, dadurch gekennzeichnet, daß das be- und entladepositionsnahe Mitnahmeelement (16) unabhängig von den trägernahen Mitnahmeelementen (15a, 15b) aus der Verschiebeebene der Leiterplatten (7) herausbewegbar sind.

19. Einrichtung zum Be- und Entladen einer Bearbeitungseinrichtung, die als Bestückeinrichtung mit (« n ») Bestückköpfen ausgebildet ist, nach einem der Ansprüche 1 bis 12, gekennzeichnet durch die Kombination folgender Merkmale :

a) « m » Aufzüge (33) sind « n » nebeneinander angeordneten Zuführbahnen (37, 38) zugeordnet,

b) die Überführvorrichtung und die Rückführvorrichtung sind zu einer Be- und Entladevorrichtung (42 ... 47) zusammengefaßt,

b1) die Be- und Entladevorrichtung (42 ... 47) weist « 2n » nebeneinander gelegene Arretierungsvorrichtungen auf,

c) der Mittenabstand benachbarter Zuführbahnen (37, 38) entspricht dem Mittenabstand benachbarter Be- und Entladepositionen (39, 40) der Bestückeinrichtung (41) und dem doppelten Mittenabstand benachbarter Arretierungsvorrichtungen

d) die Be- und Entladevorrichtung (42 ... 47) ist im Sinne der mittels der Arretierungsvorrichtungen durchführbaren Aufnahme unbestückter Leiterplatten (50, 51) an der Zuführbahn (37, 38) bzw. der Abgabe unbestückter (54, 55) und der Aufnahme bestückter Leiterplatten (52, 53) an den Be- und Entladepositionen vertikal verstellbar.

20. Einrichtung nach Anspruch 19, dadurch gekennzeichnet, daß die « n » Zuführbahnen (37, 38) auf einem Tragrahmen (36) gelagert sind, der um eine wenigstens dem Mittenabstand benachbarter Zuführbahnen entsprechende Strecke in Überführ- bzw. in Rückführrichtung verfahrbar ist.

21. Einrichtung nach einem der Ansprüche 1 bis 20, dadurch gekennzeichnet, daß die Überführvorrichtung und die Rückführvorrichtung (Be- und Entladevorrichtung (42 ... 47)) senkrecht zur Überführrichtung zwischen den Zuführbahnen (37, 38) und den Be- und Entladepositionen (39, 40) horizontal verstellbar sind.

22. Einrichtung nach Anspruch 21, dadurch gekennzeichnet, daß die Überführvorrichtung und die Rückführvorrichtung (42 ... 47) mittels eines schaltbaren Kupplungselements an eine die Be- und Entladepositionen aufnehmende Tragplatte der Bearbeitungseinrichtung (41) anschließbar ist.

23. Einrichtung nach einem der Ansprüche 1 bis 22, dadurch gekennzeichnet, daß die Zuführbahn (18) zwei Führelemente aufweist, deren Abstand in Anpassung an unterschiedliche Formate der Leiterplatten (7) verstellbar ist.

24. Einrichtung nach einem der Ansprüche 1 bis 23, dadurch gekennzeichnet, daß die Rückführvorrichtung (20 bis 28) am seitlichen Randbereich der Leiterplatten (7) angreifende Arretierungselemente (20, 21) aufweist.

25. Einrichtung nach Anspruch 24, dadurch gekennzeichnet, daß der Abstand der Arretierungselemente (20, 21) in Anpassung an unterschiedliche Formate der Leiterplatten (7) verstellbar ist.

26. Einrichtung nach Anspruch 24 oder 25, dadurch gekennzeichnet, daß die Arretierungselemente (20, 21) als federnd an den zugeordneten Randebenen der Leiterplatten (7) anliegende Klemmelemente ausgebildet sind.

27. Einrichtung nach Anspruch 26, dadurch gekennzeichnet, daß im Bereich der Zuführbahn (18) und der Be- und Entladeposition der Bearbeitungseinrichtung (10) Führungskonturen angeordnet sind, die bei Annäherung der Rückführeinrichtung die Klemmelemente (20, 21) gegen die Federkraft von den zugewandten Randebenen der Leiterplatten (7) abklappen.

## Claims

1. Apparatus for loading and unloading machines for working on circuit boards, in particular component mounting machines with carriers which are supported in a lift, and have parallel insertion planes for the circuit boards, being displaceable perpendicularly to the insertion planes in such a way that every insertion plane can be brought into the line of a supply path situated between the carriers and a loading and unloading position of the machine, onto which supply path the circuit boards can be conveyed from the carriers, and from which the circuit boards can be conveyed to the loading and unloading position by means of a drivable conveyor device, and with a returning device, which removes circuit boards which have been equipped from the loading and unloading position and initiates their return into the carriers, characterised in that the returning device (20 to 28) is constructed and controlled in such a way that circuit boards which have been processed can be drawn from the loading and unloading position (11) out of the plane of the supply path (18) and, in this position, introduced into the area between the carriers and the loading and unloading position (11) and, after a further circuit board, intermediately stored on the supply path (18), has been carried away, can be set on the supply path (18) and from there, returned into the carriers by means of a drivable loading device (15).

2. Apparatus as claimed in Claim 1, characterised in that the carriers are constructed as magazines (6) which can be drawn into and out of the lift (8).

3. Apparatus as claimed in Claim 1 or Claim 2, characterised in that the carrier or the magazine (6) can be displaced in such a way that every circuit board (7) is returned, after processing, into the insertion plane of the carrier or the magazine (6), in which it is held before being conveyed from the carrier or magazine (6) onto the supply path (18).

4. Apparatus as claimed in Claim 3, characterised in that the carrier or magazine (6), after a circuit board (7) has been conveyed from the carrier or magazine (6) onto the supply path (18), is moved back by a distance which corresponds to an integral multiple of the interval between two adjacent insertion planes, and, after receiving a processed circuit board, is moved forward out of this position by a distance which exceeds that (previously mentioned) distance by the interval between two adjacent insertion planes.

5. Apparatus as claimed in one of Claims 1 to 4, characterised in that the lift (8) is constructed as a paternoster lift.

6. Apparatus as claimed in Claim 5, characterised in that the lift (8) and the magazine (6) are co-ordinated with each other in such a way that at least two magazines (6) are carried simultaneously in the lift (8), one above the other.

7. Apparatus as claimed in Claim 6, characterised in that the interval between adjacent insertion planes of two magazines (6), one on top of the other, amounts to an integral multiple, preferably « 1 », of the interval between adjacent insertion planes within the magazines (6).

8. Apparatus as claimed in one of Claims 5 to 7, characterised in that the lift (8) is connected to two conveyor tracks (2, 3), which are spaced vertically in relation to each other and are positioned on the side of the lift (8) remote from the processing machine (10).

9. Apparatus as claimed in one of Claims 2 to 8, characterised in that fixed vertical guides (8c) of the lift (8) and lateral guide-contours of the magazine (6) are co-ordinated with each other in such a way that the magazine (6) is directed so as to be exactly vertical.

10. Apparatus as claimed in Claim 8, characterised in that the vertical guides (8c) are interrupted at the side of the lift (8) facing towards the conveyor tracks (2, 3), in an area which starts at least in the plane of the conveyor tracks (2, 3) and has a vertical measurement which is at least equivalent to the height of the magazine (6).

11. Apparatus as claimed in Claim 9 or Claim 10, characterised in that horizontal carrying components (9), fixed on circulating components (8a, 8b) of the lift (8), are constructed and arranged in such a way that the magazine (6), when it is introduced into the lift (8), is supported at one of its two edge-surfaces with horizontal guide-contours on the carrying components (9).

12. Apparatus as claimed in one of Claims 2 to 11, characterised in that a separate locking device is allocated to each insertion plane of the magazines (6), for the automatic fixing in position of a circuit board which has been inserted, which locking device is releasable at the level of the supply path by means of an activating component.

13. Apparatus as claimed in one of Claims 1 to 12, characterised in that the drivable conveying device (15, 16) which conveys the circuit boards (7) from the supply path (18) to the loading and unloading position, serves as the loading device which returns the equipped circuit boards, which have meanwhile been stored, into the carrier or the magazine (6).

14. Apparatus as claimed in Claim 13, characterised in that the conveying device and the loading device have a slider which is displaceable in the area of the supply path (18) and which has two levers (15, 16).

15. Apparatus as claimed in Claim 14, characterised in that the slider has two carrying elements (15a, 15b ; 16), spaced in relation to each other in the longitudinal direction of the supply path (18), and which can be selectively moved out of or into the plane of the supply path, in such a way that the movement of the circuit boards (7) into the loading and unloading position of the processing machine (10) takes place by means of the carrying element (16) nearer the machine, and the displacement of the circuit boards (7) into the carrier or the magazine (6) takes place by means of the carrying elements (15a, 15b) nearer the carrier.

16. Apparatus as claimed in Claim 15, characterised in that the carrying elements (15a, 15b) nearer the carrier, when in a displacement position near the loading and unloading position, serve as a stop for circuit boards (7) inserted in the supply path (18) from the carrier or the magazine (6).

17. Apparatus as claimed in Claim 15 or 16, characterised in that the carrying element (16) nearer the loading and unloading position and the carrying elements (15a, 15b) near the carrier can be moved out of the plane of movement of the circuit boards (7).

18. Apparatus as claimed in Claim 16, characterised in that the carrying element (16) near the loading and unloading position can be moved independently of the carrying elements (15a, 15b) out of the plane of movement of the circuit boards (7).

19. Apparatus for loading and unloading a processing machine which is constructed as a cladding machine with (« n ») cladding heads, as claimed in one of Claims 1 to 12, characterised in the combination of the following features :

a) « m » lifts (33) are allocated to « n » supply paths (37, 38) which are positioned next to each other,

b) the conveying device and the returning device are combined to form a loading and unloading device (42 ... 47),

b1) the loading and unloading device (42 ... 47) has « 2n » stopping devices which are positioned next to one another,

c) the centre-to-centre distance between adjacent supply paths (37, 38) corresponds to the centre-to-centre distance between adjacent loading and unloading positions (39, 40) of the cladding machine (41) and to double the centre-to-centre distance between adjacent stopping devices,

d) for the purpose of the receiving of the uncladded circuit boards (50, 51) on the supply path (37, 38), which can be carried out by means of the stopping devices, or the delivery of uncladded circuit boards (54, 55) and the collection of cladded circuit boards (52, 53) at the loading and unloading positions, the loading and unloading device (42 ... 47) is vertically displaceable.

20. Apparatus as claimed in Claim 19, characterised in that « n » supply paths (37, 38) are held on a supporting frame (36) which can be displaced in the conveying or returning direction by a distance which is at least equivalent to the centre-to-centre distance between the adjacent supply paths.

21. Apparatus as claimed in one of Claims 1 to 20, characterised in that the conveying device and the returning device [loading and unloading device (42 ... 47)] can be horizontally displaced perpendicularly to the conveying direction between the supply paths (37, 38) and the loading and unloading positions (39, 40).

22. Apparatus as claimed in Claim 21, characterised in that the conveying device and the returning device (42 ... 47) can be connected, by means of a switchable coupling component, to a carrying plate of the processing machine (41), which includes the loading and unloading positions.

23. Apparatus as claimed in one of Claims 1 to 22, characterised in that the supply path (18) has two guide-components, the distance between which can be adjusted to adapt to different formats of the printed circuit boards (7).

24. Apparatus as claimed in one of Claims 1 to 23, characterised in that the returning device (20 to 28) has catching components (20, 21) which engage the side edge region of the circuit boards (7).

25. Apparatus as claimed in Claim 24, characterised in that the distance between the catching components (20, 21) can be adjusted to adapt to different formats of the printed circuit boards (7).

26. Apparatus as claimed in Claim 24 or 25, characterised in that the catching components (20, 21) are constructed as resilient clamping components which engage the allotted edge-surfaces of the circuit boards (7).

27. Apparatus as claimed in Claim 26, characterised in that guide-contours are arranged in the area of the supply path (18) and the loading and unloading position of the processing machine (10), which guide-contours, at the approach of the return device, swing the clamping components (20, 21), against the resilient force, away from their opposed edge-surfaces of the circuit boards (7).

## Revendications

1. Dispositif pour charger et décharger des dispositifs de traitement pour des plaquettes à circuits imprimés, notamment des dispositifs de montage de composants, comportant des supports, qui sont guidés dans un élévateur, possèdent des plans parallèles d'insertion pour les plaquettes à circuits imprimés et sont déplaçables perpendiculairement aux plans d'insertion de telle sorte que chaque plan d'insertion peut être amené de niveau avec une voie d'alimentation, qui est disposée entre les supports et un poste de chargement et de déchargement du dispositif de traitement, sur lequel les plaquettes à circuits imprimés peuvent être transférées à partir des supports et à partir de laquelle les plaquettes à circuits imprimés peuvent être amenées dans le poste de chargement et de déchargement au moyen d'un dispositif de transfert pouvant être entraîné, et comportant un dispositif de renvoi prélevant des plaquettes à circuits imprimés équipées dans le poste de chargement et de déchargement et déclenchant leur retour dans les supports, caractérisé par le fait que le dispositif de renvoi (20 à 28) est agencé et commandé de telle sorte que des plaquettes à circuits imprimés traitées peuvent être retirées du poste de chargement et de déchargement (11), à partir du plan de la voie d'amenée (18) et peuvent être amenées, dans cette position, dans la zone située entre les supports et le poste de chargement et de déchargement (11) et, après l'avance d'une plaquette à circuits imprimés suivante, stockée temporairement sur la voie d'amenée (18), sont déposées sur la voie d'amenée (18) et sont renvoyées, à partir de là, dans les supports au moyen d'un dispositif d'approvisionnement (15) pouvant être entraîné.

2. Dispositif suivant la revendication 1, caractérisé par le fait que les supports sont réalisés sous la forme de magasins (6) pouvant être introduits dans l'élévateur (8) et en être ressortis.

3. Dispositif suivant la revendication 1 ou 2, caractérisé par le fait que le support ou le magasin (6) est déplaçable de telle sorte que chaque plaquette à circuits imprimés (7) est ramenée, après son traitement, dans le plan d'insertion du support ou du magasin (6), dans lequel elle est maintenue avant son transfert du support ou du magasin (6) à la voie d'amenée (18).

4. Dispositif suivant la revendication 3, caractérisé par le fait qu'après le transfert d'une plaquette à circuits imprimés (7) du support ou du magasin (6) à la voie d'amenée (18), le support ou le magasin (6) est rétracté sur un trajet correspondant à un multiple entier de la distance entre deux plans d'insertion voisins et, après réception d'une plaquette à circuits imprimés traitée, est avancé à partir de cette position, sur un trajet qui dépasse le trajet précédent, de la distance existant entre deux plans d'insertion voisins.

5. Dispositif suivant l'une des revendications 1 à 4, caractérisé par le fait que l'élévateur (8) est réalisé sous la forme d'un élévateur pater-noster.

6. Dispositif suivant la revendication 5, caractérisé par le fait que l'élévateur (8) et le magasin (6) sont réglés l'un sur l'autre de telle sorte qu'au moins deux magasins (6) sont amenés simultanément en superposition dans l'élévateur (8).

7. Dispositif suivant la revendication 6, caractérisé par le fait que la distance entre des plans voisins d'insertion de deux magasins (6) amenés en superposition est égale à un multiple entier, de préférence « 1 », de la distance entre deux plans d'insertion voisins à l'intérieur du magasin (6).

8. Dispositif suivant l'une des revendications 5 à 7, caractérisé par le fait que l'élévateur (8) est raccordé à deux voies d'entraînement (2, 3) décalées verticalement l'une par rapport à l'autre qui sont disposées sur le côté de l'élévateur (8), tourné à l'opposé du dispositif de traitement (10).

9. Dispositif suivant l'une des revendications 2 à 8, caractérisé par le fait que des guides verticaux fixes (8c) de l'élévateur (8) et les profilés latéraux de guidage du magasin (6) sont réglés les uns sur les autres de sorte que le magasin (6) est guidé exactement verticalement.

10. Dispositif suivant la revendication 8, caractérisé par le fait que les guides verticaux (8c) prévus sur le côté de l'élévateur (8), qui est tourné vers les voies d'entraînement (2, 3), sont interrompus dans une zone s'étendant au moins dans le plan des voies d'entraînement (2, 3) et possédant au moins une dimension verticale correspondant à la hauteur du magasin (6).

11. Dispositif suivant la revendication 9 ou 10, caractérisé par le fait que des organes horizontaux de support (9), qui sont fixés sur des éléments sans fin (8a, 8b) de l'élévateur (8), sont agencés et disposés de telle sorte que le magasin (6) s'appuie, lors de son introduction dans l'élévateur (8), au moyen de profilés horizontaux de guidage dans l'un de ses deux plans marginaux latéraux sur l'élément de support (9).

12. Dispositif suivant l'une des revendications 2 à 11, caractérisé par le fait qu'à chaque plan d'insertion des magasins (6) se trouve associé, pour le blocage automatique en position d'une plaquette à circuits imprimés introduite, un organe distinct de sécurité qui est détachable au moyen d'un organe d'actionnement situé à hauteur de la voie d'amenée.

13. Dispositif suivant l'une des revendications 1 à 12, caractérisé par le fait que le dispositif de transfert (15, 16), qui peut être entraîné et qui réalise le transfert des plaquettes à circuits imprimés (7) depuis la voie d'amenée (18) dans le poste de chargement et de déchargement, est utilisé en tant que dispositif d'approvisionnement ramenant dans le support ou dans le magasin (6) les plaquettes à circuits imprimés équipées, stockées temporairement.

14. Dispositif suivant la revendication 13, caractérisé par le fait que le dispositif de transfert et le dispositif d'approvisionnement comportent un poussoir, qui est déplaçable dans la zone de la voie d'amenée (18) et comporte deux leviers (15, 16).

15. Dispositif suivant la revendication 14, caractérisé par le fait que le poussoir comporte deux organes d'entraînement (15a, 15b ; 16), qui sont décalés l'un par rapport à l'autre dans la direction longitudinale de la voie d'amenée (18) et peuvent être au choix retirés du plan de la voie d'amenée ou être introduits dans ce plan, et que l'entraînement des plaquettes à circuits imprimés (16) jusque dans le poste de chargement et de déchargement du dispositif de traitement (10) réalisé au moyen de l'organe d'entraînement (16) qui est le plus rapproché du dispositif de traitement et que le déplacement des plaquettes à circuits imprimés (16) jusque dans le support ou le magasin (6) est réalisé au moyen des organes d'entraînement (15a, 15b) qui sont les plus proches des supports.

16. Dispositif suivant la revendication 15, caractérisé par le fait que les organes d'entraînement (15a, 15b), qui sont les plus proches des supports, servent, dans une position de déplacement proche du poste de chargement et de déchargement, de butée pour des plaquettes à circuits imprimés (7) insérées depuis le support ou le magasin (6) dans la voie d'amenée (18).

17. Dispositif suivant la revendication 15 ou 16, caractérisé par le fait que l'organe d'entraînement (16), qui est le plus rapproché du poste de chargement et de déchargement, et les organes d'entraînement (15a, 15b), qui sont proches du support, peuvent être déplacés en étant dégagés du plan de déplacement des plaquettes à circuits imprimés (7).

18. Dispositif suivant la revendication 16, caractérisé par le fait que l'organe d'entraînement (16), qui est proche du poste de chargement et de déchargement, peut être déplacé en étant dégagé du plan de transfert des plaquettes à circuits imprimés (7), indépendamment des organes d'entraînement (15a, 15b) proches du support.

19. Dispositif pour réaliser le chargement et le déchargement d'un dispositif de traitement qui est réalisé sous la forme d'un dispositif d'équipement comportant des têtes d'équipement (présentes en un nombre « n »), suivant l'une des revendications 1 à 12, caractérisé par la combinaison des caractéristiques suivantes :

a) « m » élévateurs (33) sont associés à « n » voies d'amenée (37, 38) disposées côte-à-côte,

b) le dispositif de transfert et le dispositif de renvoi sont réunis pour former un dispositif de chargement et de déchargement (42 ... 47),

b1) le dispositif de chargement et de déchargement (42 ... 47) comporte « 2n » dispositifs de blocage installés côte-à-côte,

c) la distance entre les axes de voies d'amenée voisines (37, 38) correspond à la distance entre les centres de postes voisins de chargement et de déchargement (39, 40) du dispositif d'équipement (41) et au double de la distance entre les axes de dispositifs de blocage voisins,

d) le dispositif de chargement et de déchargement (42 ... 47) peut être déplacé verticalement en vue de réaliser le dépôt, exécuté au moyen des dispositifs de blocage, de plaquettes à circuits imprimés non équipées (50, 51) sur la voie d'amenée (37, 38) ou le prélèvement de plaquettes à circuits imprimés non équipées (54, 55) et le dépôt de plaquettes à circuits imprimés équipées (52, 53) dans les postes de chargement et de déchargement.

20. Dispositif suivant la revendication 19, caractérisé par le fait que les « n » voies d'amenée (37, 38) sont disposées sur un cadre de support (36), qui est déplaçable dans la direction de transfert et dans la direction de renvoi, sur un trajet correspondant à la distance entre les axes de voies d'amenée voisines.

21. Dispositif suivant l'une des revendications 1 à 20, caractérisé par le fait que le dispositif de transfert et le dispositif de renvoi (dispositif de chargement et de déchargement (42 ... 47)) sont déplaçables horizontalement perpendiculairement à la direction de transfert entre les voies de guidage (37, 38) et les postes de chargement et de déchargement (39, 40).

22. Dispositif suivant la revendication 21, caractérisé par le fait que le dispositif de transfert et le dispositif de renvoi (42 ... 47) peuvent être raccordés, au moyen d'un organe d'accouplement commutable, à un plateau de support, recevant les postes de chargement et de déchargement, du dispositif de traitement (41).

23. Dispositif suivant l'une des revendications 1 à 22, caractérisé par le fait que la voie d'amenée (18) comporte deux organes de guidage, dont la distance est réglable de manière adaptée à différents formats des plaquettes à circuits imprimés (7).

24. Dispositif suivant l'une des revendications 1 à 23, caractérisé par le fait que le dispositif de renvoi (20 à 28) comporte des organes de blocage (20, 21) attaquant la zone marginale latérale des plaquettes à circuits imprimés (7).

25. Dispositif suivant la revendication 24, caractérisé par le fait que la distance entre les organes de blocage (20, 21) est réglable d'une manière adaptée à différents formats des plaquettes à circuits imprimés (7).

26. Dispositif suivant la revendication 24 ou 25, caractérisé par le fait que les organes de blocage (20, 21) sont réalisés sous la forme d'organes de serrage qui s'appliquent élastiquement contre les plans marginaux associés des plaquettes à circuits imprimés (7).

27. Dispositif suivant la revendication 26, caractérisé par le fait que dans la zone de la voie d'amenée (18) et du poste de chargement et de déchargement du dispositif de traitement (10) se trouvent disposés des profilés de guidage qui, lors du rapprochement du dispositif de renvoi, rabattent les organes de serrage (20, 21), à l'encontre de la force de ressorts, à partir des plans marginaux associés des plaquettes à circuits imprimés (7).

FIG.1

FIG.2

FIG.3

FIG.4

FIG.5

FIG.6